# EUROPÄISCHE PATENTANMELDUNG

(11) **EP 1 630 921 A1**
(43) Veröffentlichungstag der Anmeldung: **01.03.2006**
(21) Anmeldenummer: 04019508.3
(22) Anmeldetag: 17.08.2004
(51) Int. Cl.: H02G 3/32

(54) **Klemmvorrichtung**

(71) Anmelder: Delphi Technologies, Inc., Troy, MI 48007 (US)
(72) Erfinder: Urbaniak, Andreas, 48153 Münster (DE); Hoffmann, Uwe, 42781 Haan (DE); Lübstorf, Mario, 42489 Wülfrath (DE)
(74) Vertreter: Manitz, Finsterwald & Partner GbR

(57) **Zusammenfassung**

Die Erfindung betrifft eine Klemmvorrichtung (10) mit einem Grundkörper (12) und zwei einander gegenüberliegend auf einer Seite (14) des Grundkörpers (12) angeordneten und zumindest abschnittsweise flexibel ausgebildeten Klemmbügeln (18,19), die in einem nicht klemmenden Zustand der Klemmvorrichtung (10) konvex zueinander verlaufen und durch Zusammendrücken in Eingriff bringbar sind, um dadurch einen zwischen Klemmbügel (18,19) und Grundkörper (12) befindlichen Gegenstand mittels Klemmsitz an der Klemmvorrichtung (10) zu befestigen.

## Beschreibung

Die Erfindung betrifft eine Klemmvorrichtung mit einem Grundkörper und einem Klemmmittel, durch das der Grundkörper an einem Gegenstand, beispielsweise einem Flachleiter, befestigbar ist.

Eine solche Klemmvorrichtung ist grundsätzlich bekannt. Bei einer Art von Klemmvorrichtung ist ein Klemmarm mittels eines aufwändigen Scharniers an einer Seite des Grundkörpers gelagert. Der zu befestigende Gegenstand wird auf dem Grundkörper platziert, der Klemmarm darüber geklappt und das freie Ende des Klemmarms an dem Grundkörper verriegelt, um eine Klemmung des Gegenstandes zwischen Klemmarm und Grundkörper zu erreichen. Bei einer anderen Art von Klemmvorrichtung handelt es sich um ein zweiteiliges System, das einen Grundkörper und ein separates Klemmteil umfasst, die zusammensteckbar oder aufeinander aufsetzbar und miteinander verriegelbar sind, wodurch ein zwischen Grundkörper und Klemmteil angeordneter Gegenstand klemmend gehalten wird.

Als problematisch erweist sich bei beiden Klemmvorrichtungsarten, dass jeweils zwei zumindest ursprünglich separate Bauteile, nämlich der Grundkörper und das Klemmmittel zu einem komplexen Artikel zusammengefügt werden müssen. Besonders problematisch ist außerdem die Montage des voranstehend beschriebenen Scharniers sowie das Umklappen des Klemmmittels in einem automatisierten Prozess.

Der Erfindung liegt die Aufgabe zugrunde, eine vereinfachte, kostengünstig herstellbare und leicht handhabbare Klemmvorrichtung zu schaffen, die sich insbesondere gut in einen automatisierten Montageprozess integrieren lässt.

Zur Lösung der Aufgabe ist eine Klemmvorrichtung mit den Merkmalen des Anspruchs 1 vorgesehen.

Die erfindungsgemäße Klemmvorrichtung umfasst einen Grundkörper und zwei einander gegenüberliegend auf einer Seite des Grundkörpers angeordnete und zumindest abschnittsweise flexibel ausgebildete Klemmbügel, die in einem nicht klemmenden Zustand der Klemmvorrichtung konvex zueinander verlaufen und durch Zusammendrücken in Eingriff bringbar sind, um dadurch einen zwischen Klemmbügel und Grundkörper befindlichen Gegenstand mittels Klemmsitz an der Klemmvorrichtung zu befestigen.

Dadurch, dass die Klemmbügel im nicht klemmenden Zustand der Klemmvorrichtung konvex zueinander verlaufen, d.h. in einem mittleren Bereich der Klemmbügel einen größeren Abstand zueinander aufweisen als in den Endbereichen der Klemmbügel, kann ein zu klemmender Gegenstand, beispielsweise ein Flachleiter, leicht zwischen den Klemmbügeln in die Klemmvorrichtung eingelegt werden.

Eine Klemmung des Gegenstandes wird durch einfaches Zusammendrücken der Klemmbügel erreicht. Umgekehrt lässt sich die Klemmvorrichtung durch Auseinanderziehen der Klemmbügel wieder öffnen.

Beim Zusammendrücken der Klemmbügel springen diese aus ihrer konvexen Lage in eine konkave Lage über. In dieser Position ist der Abstand zwischen den Klemmbügeln im Bereich der Klemmbügelmitte geringer als im Bereich der Klemmbügelenden. Durch den konkaven Verlauf der Klemmbügel erstrecken sich diese über den in die Klemmvorrichtung eingelegten Gegenstand und üben auf diesen eine Klemmkraft aus. Dadurch ist der Gegenstand in der Klemmvorrichtung gesichert.

Das Zusammendrücken der Klemmbügel ist eine einfache translatorische Bewegung, die sich leicht automatisieren lässt. Die erfindungsgemäße Klemmvorrichtung eignet sich daher besonders gut für eine automatisierte Montage an zu klemmenden Gegenständen, insbesondere Flachleitern, wie beispielsweise flexiblen gedruckten Schaltungen (FPC), flexiblen Flachkabeln (FFC), oder extrudierten flexiblen Schaltungen (EFC).

Durch eine entsprechende Dimensionierung des Grundkörpers und der Klemmbügel lässt sich die erfindungsgemäße Klemmvorrichtung an allen auf dem Markt erhältlichen Flachleitern befestigen, ohne dass die Flachleiter zu diesem Zweck angepasst, d.h. speziell ausgebildet werden müssten.

Die erfindungsgemäße Klemmvorrichtung kann ferner für verschiedene Anwendungen vorgesehen werden, wie beispielsweise zum Schutz von elektronischen Bauteilen, z.B. als Leuchtdiodenhalter oder -gehäuse, als Steckverbinder oder als Befestigungsmittel, z.B. Clip-Halter, zur Sicherung eines Flachleiters an einem Träger oder Chassis.

Vorteilhafte Ausführungsformen der Erfindung sind den Unteransprüchen, der Beschreibung und der Zeichnung zu entnehmen.

Gemäß einer vorteilhaften Ausführungsform der erfindungsgemäßen Klemmvorrichtung sind die Klemmbügel im zusammengedrückten Zustand aneinander fixierbar. Dadurch wird verhindert, dass die zusammengedrückten Klemmbügel selbsttätig wieder aufspringen können. Somit ist eine dauerhaft zuverlässige Halterung des Gegenstandes in der Klemmvorrichtung gewährleistet.

Vorzugsweise weisen die Klemmbügel jeweils komplementär ausgebildete Verschlussmittel, insbesondere Rastmittel, für eine Fixierung der Klemmbügel im zusammengedrückten Zustand auf. Dies ermöglicht eine besonders einfache Verriegelung der Klemmbügel im zusammengedrückten Zustand.

Besonders vorteilhaft ist es, wenn die Verschlussmittel derart ausgebildet sind, dass sie im fixierten Zustand der Klemmbügel eine Verdrehung wenigstens eines Klemmbügels bewirken, durch die ein Zwischenraum zwischen dem Klemmbügel und dem Grundkörper verringert und eine Klemmkraft in Richtung des Grundkörpers ausgeübt wird. Dadurch, dass die Verschlussmittel nicht nur der Verriegelung der Klemmbügel dienen, sondern auch noch eine für die Klemmkraft verantwortliche Verdrehung der Klemmbügel im verriegelten Zustand bewirken, erfüllen die Verschlussmittel eine Doppelfunktion. Dies vereinfacht den Aufbau der Klemmvorrichtung und ermöglicht eine Herstellung der Klemmvorrichtung mit geringerem wirtschaftlichem Aufwand.

Die Verschlussmittel können sich quer zur Längserstreckung der Klemmbügel und im Wesentlichen über die gesamte Breite der Klemmbügel erstrecken. Dadurch ist die Zuverlässigkeit der Verriegelung der Klemmbügel im zusammengedrückten Zustand erhöht.

Bevorzugt weist das Verschlussmittel wenigstens eines Klemmbügels in einem vom Grundkörper abgewandten Bereich eine geringere Höhe bezüglich des Klemmbügels auf als in einem dem Grundkörper zugewandten Bereich. Dadurch wird auf einfache Weise eine Verdrehung wenigstens eines Klemmbügels derart erreicht, dass der zum Grundkörper weisende Rand des Klemmbügels in Richtung des Grundkörpers ausgelenkt wird. Dies führt zu einer Verringerung der Spaltbreite eines zwischen dem Klemmbügel und dem Grundkörper vorgesehenen Zwischenraums und somit zur Ausübung einer Klemmkraft auf einen in diesem Zwischenraum angeordneten Gegenstand.

Gemäß einer weiteren Ausführungsform ist jeder Klemmbügel durch mehrere jeweils plane Bügelabschnitte gebildet, die zumindest im nicht klemmenden Zustand der Klemmvorrichtung im Wesentlichen rechtwinklig zu einer Oberfläche des Grundkörpers orientiert sind. Die Ausbildung von planen Bügelabschnitten vereinfacht die Herstellung der Klemmvorrichtung und erhöht gleichzeitig deren Stabilität. Die im Wesentlichen rechtwinklige Orientierung der Bügelabschnitte zu der Oberfläche des Grundkörpers vereinfacht das Zusammendrücken bzw. Auseinanderziehen der Klemmbügel und das Überspringen der Klemmbügel aus ihrer konvexen in ihre konkave Lage bzw. umgekehrt aus ihrer konkaven in ihre konvexe Lage. Grundsätzlich ist es auch möglich, die Klemmbügel rundbogenförmig auszubilden.

Vorzugsweise ist jedes Ende der Klemmbügel an einem Lagerpfosten befestigt, der insbesondere jeweils in einem Eckbereich des Grundkörpers angeordnet ist und bevorzugt eine Führung für den an der Klemmvorrichtung zu befestigenden Gegenstand bildet. Auch die Lagerpfosten können somit eine Doppelfunktion erfüllen, nämlich zum einen der Lagerung der Klemmbügel dienen und zum anderen für eine korrekte Ausrichtung des zu klemmenden Gegenstandes in der Klemmvorrichtung sorgen.

Vorteilhafterweise sind aneinander angrenzende Bügelabschnitte der Klemmbügel und/oder die Klemmbügel und Lagerpfosten filmscharnierartig miteinander verbunden. Durch die filmscharnierartige Verbindung der einzelnen Bügelabschnitte untereinander bzw. der Klemmbügel und der Lagerpfosten wird auf einfache Weise eine Flexibilität der Klemmbügel erreicht, die das Zusammendrücken der Klemmbügel und die Ausübung einer Klemmkraft auf einen zwischen Klemmbügel und Grundkörper angeordneten Gegenstand ermöglicht. Bevorzugt werden die jeweiligen Filmscharniere durch eine Verjüngung des Klemmbügelmaterials quer zur Längserstreckung der Klemmbügel gebildet. Gleichzeitig kann durch eine entsprechend verstärkte Ausbildung der Bügelabschnitte bzw. der Lagerpfosten die Stabilität der Klemmvorrichtung erhöht werden.

Gemäß einer weiteren Ausführungsform sind an der den Klemmbügeln abgewandten Seite des Grundkörpers Befestigungsmittel, insbesondere Clip-Federelemente oder Rastlaschen, zur Befestigung der Klemmvorrichtung an einem Träger vorgesehen. Mit Hilfe der Klemmvorrichtung lässt sich der zu klemmende Gegenstand, z.B. Flachleiter, dadurch auf einfache Weise und insbesondere lösbar an einem Träger oder Chassis befestigen.

Der Grundkörper kann wenigstens eine Aussparung für ein elektronisches Bauelement aufweisen, das mit einer an der Klemmvorrichtung zu befestigenden elektrischen Leitung verbunden ist. Die Klemmvorrichtung kann somit ein einfach zu montierendes Schutzgehäuse für das elektronische Bauelement bilden.

Vorteilhafterweise sind die Klemmbügel einstückig mit dem Grundkörper ausgebildet. Dadurch ist die Klemmvorrichtung nicht nur besonders günstig herstellbar, z.B. als Kunststoffspritzgussteil, sondern auch besonders einfach zu handhaben.

Nachfolgend wird die Erfindung rein beispielhaft anhand vorteilhafter Ausführungsformen unter Bezugnahme auf die Zeichnung beschrieben. Es zeigen:
- Fig. 1: eine Ausführungsform der erfindungsgemäßen Klemmvorrichtung im nicht klemmenden Zustand;
- Fig. 2: die Klemmvorrichtung von Fig. 1 mit zusammengedrückten Klemmbügeln;
- Fig. 3A - C: eine Abfolge von Montageschritten zur Befestigung eines Flachleiters in der Klemmvorrichtung von Fig. 1;
- Fig. 4: eine Rückseitenansicht der Klemmvorrichtung von Fig. 1; und
- Fig. 5: eine perspektivische Ansicht einer weiteren Ausführungsform der erfindungsgemäßen Klemmvorrichtung.

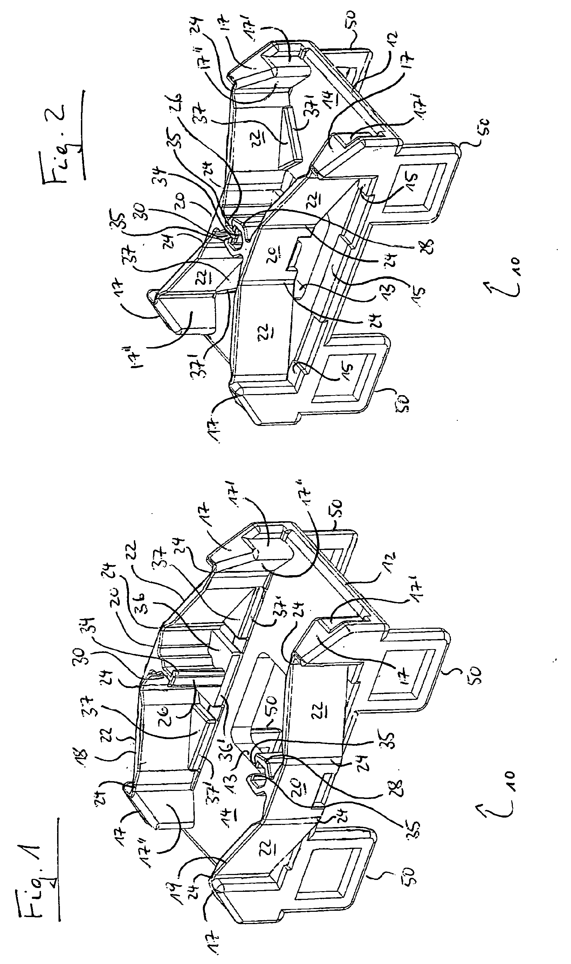

Fig. 1 zeigt eine erste Ausführungsform der erfindungsgemäßen Klemmvorrichtung 10, die einstückig ausgebildet ist und ein Kunststoffmaterial aufweist. Bei der Klemmvorrichtung 10 kann es sich beispielsweise um ein Spritzgussteil handeln.

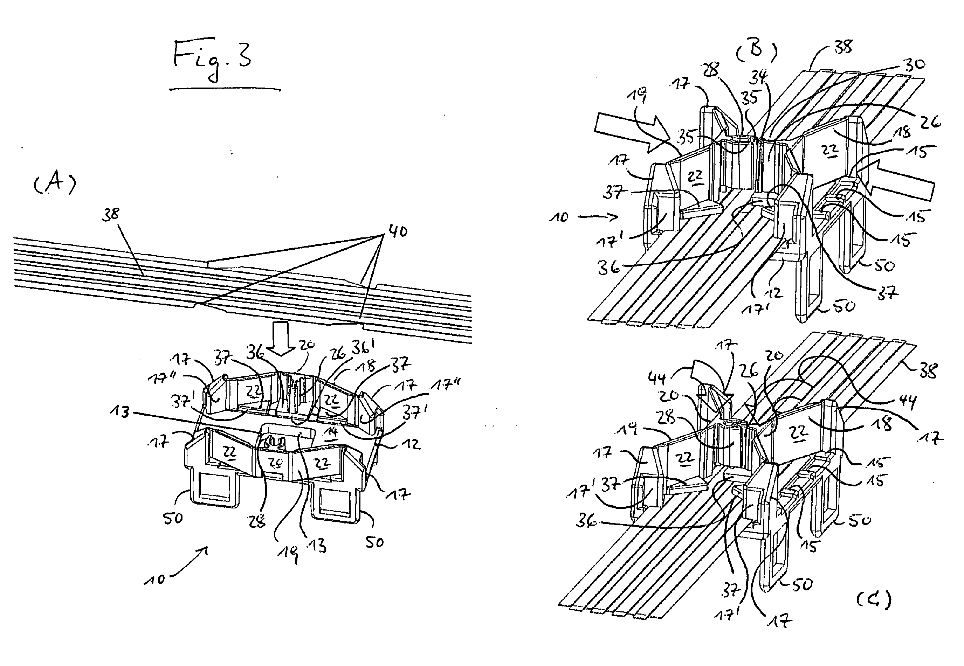

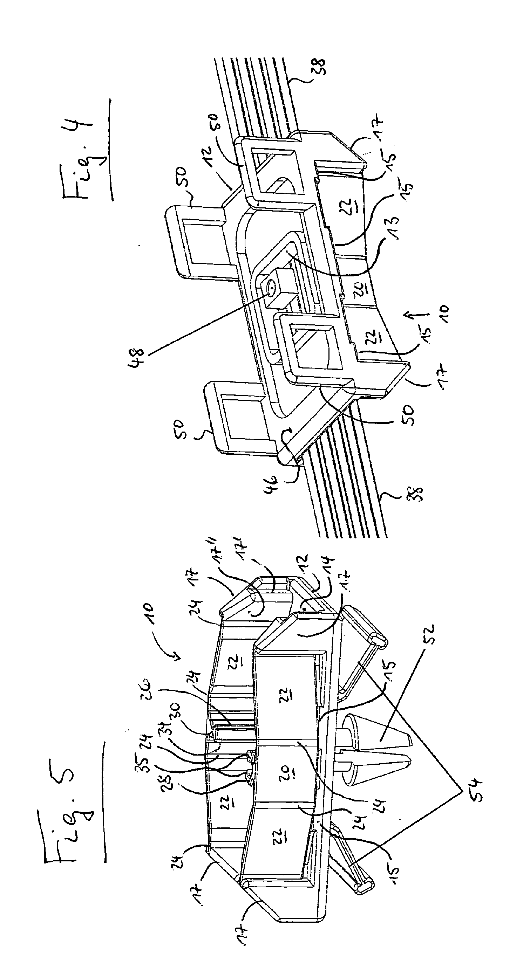

Die Klemmvorrichtung 10 umfasst einen Grundkörper 12 der im dargestellten Ausführungsbeispiel die Form einer rechteckigen Platte aufweist. Beide Seiten der Platte sind im Wesentlichen plan ausgebildet. In einem zentralen Bereich der Platte ist eine im Wesentlichen rechteckige Aussparung 13 des Grundkörpers 12 vorgesehen, deren Zweck in Verbindung mit Fig. 4 näher erläutert wird.

Auf der einen Seite des Grundkörpers 12, die im Folgenden Vorderseite 14 genannt wird, sind entlang der Längsränder des Grundkörpers 12 Führungsvorsprünge 15 angeordnet, deren Zweck im Zusammenhang mit Fig. 3A näher beschrieben wird.

Ferner sind auf der Vorderseite 14 vier Lagerpfosten 16 vorgesehen, wobei jeder Lagerpfosten 16 in einem Eckbereich des Grundkörpers 12 angeordnet und im Wesentlichen rechtwinklig zur Vorderseite 14 des Grundkörpers 12 orientiert ist.

Jeder Lagerpfosten 16 weist einen Vorsprung 17 auf, der sich zur Längsmittelebene des Grundkörpers 12 hin erstreckt und der eine erste Seite 17', die rechtwinklig zur Längsquerschnittsebene des Grundkörpers 12 orientiert ist und zum Rand des Grundkörpers 12 weist, und eine zweite Seite 17" umfasst, die schräg zur ersten Seite 17' orientiert ist und zum jeweils diagonal gegenüber liegenden Lagerpfosten 16 weist. Der Zweck der Vorsprünge 17 wird in Verbindung mit Fig. 3A erläutert.

Die Lagerpfosten 16 dienen zur Lagerung zweier Klemmbügel 18, 19, die sich auf gegenüberliegenden Längsseiten des Grundkörpers 12 jeweils zwischen den entsprechenden, in Längsrichtung hintereinander angeordneten Lagerpfosten 16 erstrecken. Die unteren Ränder der Klemmbügel 18, 19 weisen einen Abstand zur Vorderseite 14 des Grundkörpers 12 derart auf, dass sich die Klemmbügel 18, 19, wie in Verbindung mit Fig. 3 beschrieben wird, über einen in der Klemmvorrichtung 14 zu befestigender Gegenstand, z.B. Flachleiter, hinweg bewegen können.

Jeder Klemmbügel 18, 19 ist durch drei Bügelabschnitte gebildet, nämlich durch einen mittleren Abschnitt 20 und zwei Endabschnitte 22, die sich auf gegenüberliegenden Seiten des mittleren Abschnitts 20 an diesen anschließen. An ihren jeweils vom mittleren Abschnitt 20 wegweisenden Enden sind die Endabschnitte 22 mit den jeweiligen Lagerpfosten 16 verbunden.

Sowohl der mittlere Abschnitt 20 als auch die Endabschnitte 22 der Klemmbügel 18, 19 weisen eine derartige Materialstärke auf, dass sie im Wesentlichen starr sind. Lediglich in den Übergangsbereichen 24 zwischen den Endabschnitten 22 und dem mittleren Abschnitt 20 bzw. zwischen den Endabschnitten 22 und den jeweiligen Lagerpfosten 16 weisen die Klemmbügel 18, 19 eine vergleichsweise geringe Materialstärke auf, um den Klemmbügeln 18, 19 eine gewisse Flexibilität zu verleihen. Jeder Übergangsbereich 24 bildet somit ein Filmscharnier.

Die Länge der Klemmbügel 18, 19 ist größer als der Abstand zwischen den Lagerpfosten 16, an denen die Klemmbügel 18, 19 jeweils gelagert sind. Die Klemmbügel 18, 19 erstrecken sich daher nicht geradlinig zwischen ihren jeweiligen Lagerpfosten 16, sondern weisen einen gekrümmten Verlauf auf. Dabei beschrieben die Klemmbügel 18, 19 des dargestellten Ausführungsbeispiels in der Draufsicht auf die Vorderseite 14 keine kreisbogenförmige Krümmung, sondern eine Folge von zueinander abgewinkelten geraden Segmenten, die durch eine mehrfache Abwinkelung der Klemmbügel 18, 19 in den jeweiligen filmscharnierartigen Übergangsbereichen 24 hervorgerufen wird.

Fig. 1 zeigt die Klemmvorrichtung im nicht klemmenden Zustand, d.h. in einem offenen Zustand der Klemmvorrichtung 10. In diesem Zustand sind die Klemmbügel 18, 19 bezüglich der Mitte des Grundkörpers 12 konvex nach außen gekrümmt, d.h. die mittleren Abschnitte 20 der Klemmbügel 18, 19 weisen einen größeren Abstand zueinander auf als die mit den Lagerpfosten 16 verbundenen Enden der Klemmbügel 18, 19.

Durch Zusammendrücken der Klemmbügel 18, 19 können diese aus ihrer konvexen Lage in eine konkave Lage, d.h. in einen geschlossenen Zustand der Klemmvorrichtung 10, gebracht werden, in der die Klemmbügel 18, 19 im Bereich ihrer mittleren Abschnitte 20 einen geringeren Abstand aufweisen als im Bereich ihrer an den Lagerpfosten 16 gelagerten Enden, wie es in Fig. 2 dargestellt ist.

Zum Zusammendrücken der Klemmbügel 18, 19 ist es nicht erforderlich, während der gesamten Verformung der Klemmbügel 18, 19 eine Kraft auf die Klemmbügel 18, 19 auszuüben. Vielmehr reicht es aus, einen gewissen Druckpunkt zu überwinden, welcher etwa die Grenze zwischen der konvexen und der konkaven Krümmung der Klemmbügel 18, 19 markiert. Nach Überwindung dieses Druckpunkts springen die Klemmbügel 18, 19 selbsttätig auf die andere Seite einer gedachten Ebene über, welche durch die Lagerpfosten 16 des jeweiligen Klemmbügels 18, 19 verläuft.

Zum Schutz vor einem unbeabsichtigten Zurückspringen eines Klemmbügels oder beider Klemmbügel 18, 19 aus der konkaven in die konvexe Lage weisen die Klemmbügel 18, 19 Verschlussmittel zur Verriegelung der Klemmbügel 18, 19 im zusammengedrückten Zustand auf. Diese Verschlussmittel sind durch Rastmittel 26, 28 gebildet, die jeweils im Bereich der mittleren Abschnitte 20 der Klemmbügel 18, 19 vorgesehen sind.

Das Rastmittel 26 des ersten Klemmbügels 18 umfasst einen Steg 30, der quer zur Längserstreckung des Klemmbügels 18 und im Wesentlichen über die gesamte Breite des Klemmbügels 18 verläuft. Der Steg 30 geht aus dem mittleren Abschnitt 20 des Klemmbügels 18 hervor und erstreckt sich in Richtung des zweiten Klemmbügels 19. An seinem vom mittleren Abschnitt 20 wegweisenden Ende ist der Steg 30 mit einer Verbreiterung 34 versehen, so dass das Rastmittel 26 des ersten Klemmbügels 18 im Profil, d.h. in der Draufsicht auf die Vorderseite 14 des Grundkörpers, eine Pilz- oder T-Form aufweist.

Das Rastmittel 28 des zweiten Klemmbügels 19 verläuft ebenfalls quer zur Längserstreckung des Klemmbügels 19 und im Wesentlichen über die gesamte Breite des Klemmbügels 19. Ferner erstreckt es sich ausgehend von dem mittleren Abschnitt 20 des Klemmbügels 19 in Richtung des ersten Klemmbügels 18. Das Rastmittel 28 weist ein kelch- oder U-förmiges Profil auf, wobei an den freien Enden des Profils jeweils nach innen, d.h. zueinander weisende Rasthaken 35 vorgesehen sind.

Wie in Fig. 2 dargestellt ist, sind die Rastmittel 26, 28 derart komplementär zueinander ausgebildet, dass das Rastmittel 26 des ersten Klemmbügels 18 im zusammengedrückten Zustand der Klemmbügel 18, 19 in das Rastmittel 28 des zweiten Klemmbügels 19 so einschnappt, dass die Rasthaken 35 des zweiten Rastmittels 28 die Verbreiterung 34 des ersten Rastmittels 26 hintergreifen, wodurch eine Rastverbindung zwischen den Rastmitteln 26, 28 und somit zwischen den Klemmbügeln 18, 19 geschaffen wird.

Im unteren Randbereich des mittleren Abschnitts 20 des ersten Klemmbügels 18 ist eine rechteckige Klemmplatte 36 angeformt, die rechtwinklig zum mittleren Abschnitt 20 orientiert ist. Im nicht zusammengedrückten Zustand, d.h. in der konvexen Lage der Klemmbügel 18, 19 verläuft die Klemmplatte 36 somit etwa parallel zur Vorderseite 14 des Grundkörpers 12. Die Ausdehnung der Klemmplatte 36 entlang des Klemmbügels 18 entsprecht etwa der Länge des mittleren Abschnitts 20, während ihre Ausdehnung in zum Klemmbügel 18 senkrechter Richtung etwa der Höhe des Rastmittels 26 bezüglich des mittleren Abschnitts 20 an seinem dem Grundkörper 12 zugewandten Ende entspricht.

An jedem Endabschnitt 22 der Klemmbügel 18, 19 ist ferner eine Klemmlasche 37 vorgesehen, die sich von einem unteren Randbereich der Endabschnitte 22 ausgehend rechwinklig zu diesen in Richtung zum jeweils anderen Klemmbügel 18, 19 erstreckt. Die Klemmlaschen 37 weisen eine dreieckige Form derart auf, dass jeweils ein Rand 37' der Klemmlaschen 37 in der konkaven Lage der Klemmbügel 18, 19, d.h. im nicht zusammengedrückten Zustand der Klemmbügel 18, 19 parallel zur Längsmittelachse des Grundkörpers 12 verlaufen, wobei die Ränder 37' der Endabschnitte 22 jeweils eines Klemmbügels 18, 19 miteinander ausgerichtet sind. Zusätzlich ist auch der von dem ersten Klemmbügel 18 wegweisende Rand 36' der Klemmplatte 36 mit den Ränder 37' der Klemmlaschen 37 des ersten Klemmbügels ausgerichtet.

Im offenen Zustand der Klemmvorrichtung 10 schaffen die Klemmplatte 36 und die Klemmlaschen 37 dadurch Raum zum Einlegen eines zu klemmenden Gegenstandes in die Klemmvorrichtung 10.

Anhand von Fig. 3 wird nun die Montage der Klemmvorrichtung 10 an einem Flachleiter 38 erläutert.

Wie Fig. 3A zu entnehmen ist, wird der Flachleiter 38 zunächst mit vier seitlichen Aussparungen 40 versehen. Die Positionierung und Kontur der Aussparungen 40 sind an die Vorsprünge 17 der Lagerpfosten 16 angepasst.

Der Flachleiter 38 wird zwischen den sich in konvexer Lage befindlichen Klemmbügeln 18, 19 in die Klemmvorrichtung 10 eingelegt und derart auf der Vorderseite 14 des Grundkörpers 12 angeordnet, dass die Vorsprünge 17 der Lagerpfosten 16 in die Aussparungen 40 des Flachleiters 38 eingreifen. Durch die in die Aussparungen 40 eingreifenden Vorsprünge 17 ist der Flachleiter 38 gegen eine Bewegung in Längsrichtung relativ zur Klemmvorrichtung 10 gesichert. Durch die zwischen den Lagerpfosten 16 entlang der Längsseiten des Grundkörpers 12 angeordneten Führungsvorsprünge 15 ist der Flachleiter 38 außerdem seitlich geführt. Die Führungsvorsprünge 15 stellen zusammen mit den Lagerpfosten 16 also eine exakte Ausrichtung des Flachleiters 38 bezüglich der Klemmvorrichtung 10 sicher.

Zur Klemmung des Flachleiters 38 in der Klemmvorrichtung 10 werden die Klemmbügel 18, 19 zusammengedrückt (Fig. 3B) und durch die Rastmittel 26, 28 aneinander fixiert (Fig. 3C).

Wie in Fig. 3C durch die Pfeile 44 angedeutet ist, bewirkt die Verrastung der Klemmbügel 18, 19 eine Verdrehung der Klemmbügel 18, 19 derart, dass diese eine Klemmkraft auf den Flachleiter 38 ausüben, durch welche der Flachleiter 38 mittels Klemmsitz in der Klemmvorrichtung 10 fixiert wird. Die Verdrehung der Klemmbügel 18, 19 wird durch eine spezielle Ausbildung der Rastmittel 26, 28 erreicht.

Wie in Fig. 3B zu erkennen ist, weisen die Rastmittel 26, 28 in ihren vom Grundkörper 12 abgewandten Bereich eine geringere Höhe bezüglich des jeweiligen Klemmbügels 18, 19 auf als in ihrem dem Grundkörper 12 zugewandeten Bereich. Diese in Richtung des Grundkörpers anwachsende Höhe der Rastmittel 26, 28 bewirkt beim Verrasten der Rastmittel 26, 28 eine Verkippung der mittleren Abschnitte 20 der Klemmbügel 18, 19 derart, dass die vom Gehäuse 12 wegweisenden Ränder der mittleren Abschnitte 20 zusammengezogen und die zum Grundkörper 12 weisenden Ränder der mittleren Abschnitte 20 der Klemmbügel 18, 19 auseinandergedrückt werden.

Diese Verkippung der mittleren Abschnitte 20 führt dazu, dass die zum Grundkörper 12 weisenden Ränder der Klemmbügel 18, 19 in Richtung des Grundkörpers 12 ausgelenkt werden. Gleichzeitig bewirkt die Verkippung der mittleren Abschnitte 20 eine Verkippung der an dem mittleren Abschnitt 20 des ersten Klemmbügels 18 vorgesehenen Klemmplatte 36 und der an den Endabschnitten 22 der Klemmbügel 18, 19 vorgesehenen Klemmlaschen 37.

Im Ergebnis werden die von ihren jeweiligen Klemmbügeln 18, 19 wegweisenden Bereiche der Klemmplatte 36 und Klemmlaschen 37 durch die Verkippung der mittleren Bügelabschnitte 20 und die dadurch bedingte Verdrehung der Klemmbügel 18, 19 in Richtung des Grundkörpers 12 auf den zu klemmenden Flachleiter 38 gedrückt. Der Flachleiter 38 ist dadurch sicher in der Klemmvorrichtung 10 gehalten.

Fig. 4 zeigt die Rückseite 46 der nunmehr an dem Flachleiter 38 befestigten Klemmvorrichtung 10. In der Aussparung 13 des Grundkörpers 12 ist eine an den Flachleiter 38 angeschlossene Leuchtdiode 48 angeordnet. Auf der Rückseite 46 des Grundkörpers 12 sind ferner vier Rastlaschen 50 vorgesehen, die in den Eckbereichen des Grundkörpers 12 angeordnet sind und sich im Wesentlichen rechtwinklig zur Rückseite 46 des Grundkörpers 12 erstrecken. Die Rastlaschen 50 dienen zur Befestigung eines nicht dargestellten Deckels am Grundkörper 12, durch den die Leuchtdiode 48 vor äußeren Einflüssen geschützt werden kann.

In Fig. 5 ist eine weitere Ausführungsform der erfindungsgemäßen Klemmvorrichtung 10 gezeigt, die sich von der in den Fig. 1 bis 4 dargestellten ersten Ausführungsform lediglich darin unterscheidet, dass der Grundkörper 12 keine Aussparung 13 aufweist und dass anstelle von Rastlaschen 50 ein mittig angeordnetes Clip-Federelement 52 sowie zwei zusätzliche Stützfederelemente 54 an der Rückseite 46 des Grundkörpers 12 vorgesehen sind, durch welche die Klemmvorrichtung 10 an einem entsprechend ausgebildeten Träger oder Chassis befestigbar ist. Die in Fig. 5 dargestellte Klemmvorrichtung 10 ermöglicht somit eine schnelle und einfache Montage eines Flachleiters an dem Träger oder Chassis.

Sowohl bei der ersten als auch bei der zweiten Ausführungsform der Klemmvorrichtung 10 ist die Befestigung des Flachleiters 38 an der Klemmvorrichtung 10 leicht lösbar: die Klemmbügel 18, 19 müssen lediglich auseinander gezogen und der Flachleiter 38 der Klemmvorrichtung 10 entnommen werden.

### Bezugszeichenliste

- 10: Klemmvorrichtung
- 12: Grundkörper
- 13: Aussparung
- 14: Vorderseite
- 15: Führungsvorsprung
- 16: Lagerpfosten
- 17: Vorsprung
- 17': Seite
- 17": Seite
- 18: Klemmbügel
- 19: Klemmbügel
- 20: mittlerer Abschnitt
- 22: Endabschnitt
- 24: Übergangsbereich
- 26: Rastmittel
- 28: Rastmittel
- 30: Steg
- 34: Verbreiterung
- 35: Rasthaken
- 36: Klemmplatte
- 36: Rand
- 37: Klemmlasche
- 37': Rand
- 38: Flachleiter
- 40: Aussparung
- 44: Pfeil
- 46: Rückseite
- 48: Leuchtdiode
- 50: Rastlasche
- 52: Clip-Federelement
- 54: Stützfederelement

## Patentansprüche

1. Klemmvorrichtung (10) mit einem Grundkörper (12) und zwei einander gegenüberliegend auf einer Seite (14) des Grundkörpers (12) angeordneten und zumindest abschnittsweise flexibel ausgebildeten Klemmbügeln (18, 19), die in einem nicht klemmenden Zustand der Klemmvorrichtung (10) konvex zueinander verlaufen und durch Zusammendrücken in Eingriff bringbar sind, um dadurch einen zwischen Klemmbügel (18, 19) und Grundkörper (12) befindlichen Gegenstand (38) mittels Klemmsitz an der Klemmvorrichtung (10) zu befestigen.

2. Klemmvorrichtung nach Anspruch 1,
**dadurch gekennzeichnet,**
**dass** die Klemmbügel (18, 19) im zusammengedrückten Zustand aneinander fixierbar sind.

3. Klemmvorrichtung nach Anspruch 1 oder 2,
**dadurch gekennzeichnet,**
**dass** die Klemmbügel (18, 19) jeweils komplementär ausgebildete Verschlussmittel (26, 28), insbesondere Rastmittel, für eine Fixierung der Klemmbügel (18, 19) im zusammengedrückten Zustand aufweisen.

4. Klemmvorrichtung nach Anspruch 3,
**dadurch gekennzeichnet,**
**dass** die Verschlussmittel (28, 28) derart ausgebildet sind, dass sie im fixierten Zustand der Klemmbügel (18, 19) eine Verdrehung wenigstens eines Klemmbügels (18, 19) bewirken, durch die ein Zwischenraum zwischen dem Klemmbügel (18, 19) und dem Grundkörper (12) verringert und eine Klemmkraft in Richtung des Grundkörpers (12) ausgeübt wird.

5. Klemmvorrichtung nach Anspruch 3 oder 4,
**dadurch gekennzeichnet,**
**dass** sich die Verschlussmittel (26, 28) quer zur Längserstreckung der Klemmbügel (18, 19) und im Wesentlichen über die gesamte Breite der Klemmbügel (18, 19) erstrecken.

6. Klemmvorrichtung nach einem der Ansprüche 3 bis 5,
**dadurch gekennzeichnet,**
**dass** das Verschlussmittel (26, 28) wenigstens eines Klemmbügels (18, 19) in einem vom Grundkörper (12) abgewandten Bereich eine geringere Höhe bezüglich des Klemmbügels (18, 19) aufweist als in einem dem Grundkörper (12) zugewandten Bereich.

7. Klemmvorrichtung nach einem der vorherigen Ansprüche,
**dadurch gekennzeichnet,**
**dass** jeder Klemmbügel (18, 19) durch mehrere jeweils plane Bügelabschnitte (20, 22) gebildet ist, die zumindest im nicht klemmenden Zustand der Klemmvorrichtung (10) im Wesentlichen rechtwinklig zu einer Oberfläche des Grundkörpers (12) orientiert sind.

8. Klemmvorrichtung nach einem der vorherigen Ansprüche,
**dadurch gekennzeichnet,**
**dass** jedes Ende der Klemmbügel (18, 19) an einem Lagerpfosten (16) befestigt ist, der insbesondere jeweils in einem Eckbereich des Grundkörpers (12) angeordnet ist und vorzugsweise eine Führung für den an der Klemmvorrichtung (10) zu befestigenden Gegenstand (38) bildet.

9. Klemmvorrichtung nach Anspruch 7 oder 8,
**dadurch gekennzeichnet,**
**dass** aneinander angrenzende Bügelabschnitte (20, 22) der Klemmbügel (18, 19) und/oder die Klemmbügel (18, 19) und Lagerpfosten (16) filmscharnierartig miteinander verbunden sind.

10. Klemmvorrichtung nach einem der vorherigen Ansprüche,
**dadurch gekennzeichnet,**
**dass** an der den Klemmbügeln (18, 19) abgewandten Seite (46) des Grundkörpers (12) Befestigungsmittel (50, 52, 54), insbesondere Clip-Federelemente oder Rastlaschen, zur Befestigung der Klemmvorrichtung (10) an einem Träger vorgesehen sind.

11. Klemmvorrichtung nach einem der vorherigen Ansprüche,
**dadurch gekennzeichnet,**
**dass** der Grundkörper (12) wenigstens eine Aussparung (13) für ein elektronisches Bauelement (48) aufweist, das mit einer an der Klemmvorrichtung (10) zu befestigenden elektrischen Leitung (38) verbunden ist.

12. Klemmvorrichtung nach einem der vorherigen Ansprüche,
**dadurch gekennzeichnet,**
**dass** die Klemmbügel (18, 19) einstückig mit dem Grundkörper (12) ausgebildet sind.
